# FASCICULE DE BREVET EUROPEEN

(11) **EP 2 273 548 B1**
(45) Date de publication et mention de la délivrance du brevet: **17.10.2018**
(21) Numéro de dépôt: 10168442.1
(22) Date de dépôt: 05.07.2010
(51) Int. Cl.: H01L 23/544, B81C 3/00, H01L 21/68, H01L 21/683

(54) **Procédé de réalisation d'une plaquette poignée presentant des fenêtres de visualisation**
Verfahren zur Herstellung eines temporären Trägerwafers, der Sichtfenster enthält
Method of manufacturing a handle wafer with viewing windows

(30) Priorité: 09.07.2009 FR 0954779
(43) Date de publication de la demande: 12.01.2011
(73) Titulaire: Commissariat à l'Énergie Atomique et aux Énergies Alternatives, 75015 Paris (FR)
(72) Inventeur: Souriau, Jean-Charles, 38120 Saint-Égrève (FR); Caplet, Stéphane, 38360 Sassenage (FR)
(74) Mandataire: Ilgart, Jean-Christophe

(56) Documents cités:
- WO-A1-2009/061050
- US-A1- 2007 004 171
- US-A1- 2009 017 580

## Description

### DOMAINE TECHNIQUE ET ART ANTÉRIEUR

L'invention se rapporte aux procédés microélectroniques ou mettant en oeuvre des microsystèmes.

Dans de tels procédés on peut avoir à réaliser un alignement sur des motifs qui sont eux-mêmes masqués par exemple par un support temporaire (dit poignée) ou par un capot.

Ce cas se présente par exemple lorsqu'on utilise une plaquette de matériau semi-conducteur amincie, d'épaisseur inférieure à 300µm. Une telle plaquette est alors très fragiles et il n'est pas possible de la manipuler dans des équipements conventionnels de microélectronique.

Un exemple typique de procédé nécessitant un alignement est la photolithographie. L'alignement avec le masque de photolithographie est réalisé avec des motifs gravés sur la plaquette semi-conductrice. Là encore, un support temporaire (ou poignée) masque ces marques d'alignement.

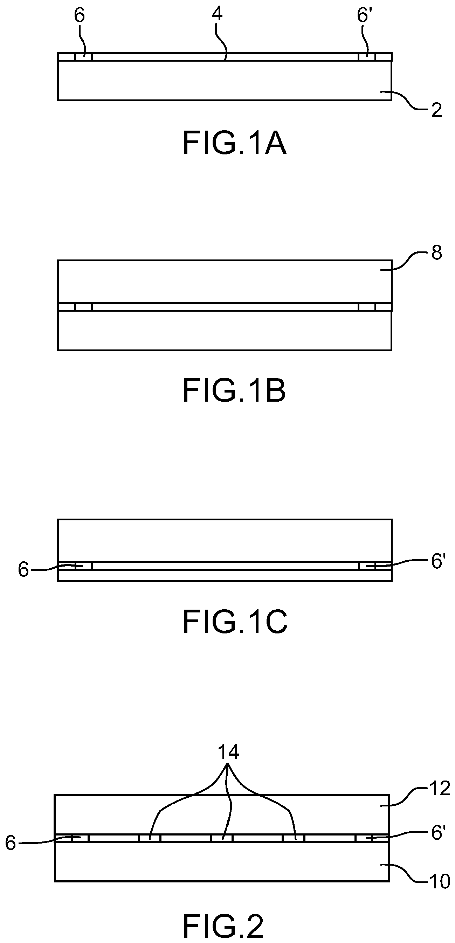

La figure 1A représente une plaquette 2 qui comporte, sur sa face avant 4, des zones d'alignement 6, 6'. Ces zones, comportant des marques ou mires d'alignement, vont permettre de disposer des composants et/ou tout autre élément semi-conducteur, par exemple une autre plaquette, dans une certaine position par rapport à la surface 4 du substrat 2. Cette plaquette 2 est reportée par sa face avant sur une plaquette 8 poignée (figure 1B). Mais cette dernière masque alors les marques ou mires d'alignement 6, 6' et empêche de réaliser l'alignement souhaité. La figure 1C représente la même plaquette 2, après une opération d'amincissement, les marques ne sont toujours pas visibles.

Un autre cas qui peut se présenter est celui illustré en figure 2 où un capot 12 est reporté sur la face avant d'une plaquette 10 comportant des zones sensibles 14 à protéger (par exemple comportant un MEMS, ou un NEMS, ou un MOEMS etc...).

Dans ce cas, comme dans le précédent, les zones d'alignement 6, 6' se retrouvent masquées par le capot 12 et ne sont plus visibles.

A ce jour, les solutions apportées proposent d'utiliser une plaquette poignée 8 transparente ou un capot 12 transparent.

Une plaquette poignée transparente est mentionnée dans le document US 2007/0004171 A1.

Cependant lorsque des plaquettes de natures différentes sont assemblées à des températures élevées, la différence d'expansion thermique les deux plaquettes conduit à une déformation de l'ensemble lors d'un retour à la température ambiante. C'est le cas avec des plaquettes en matériau transparent.

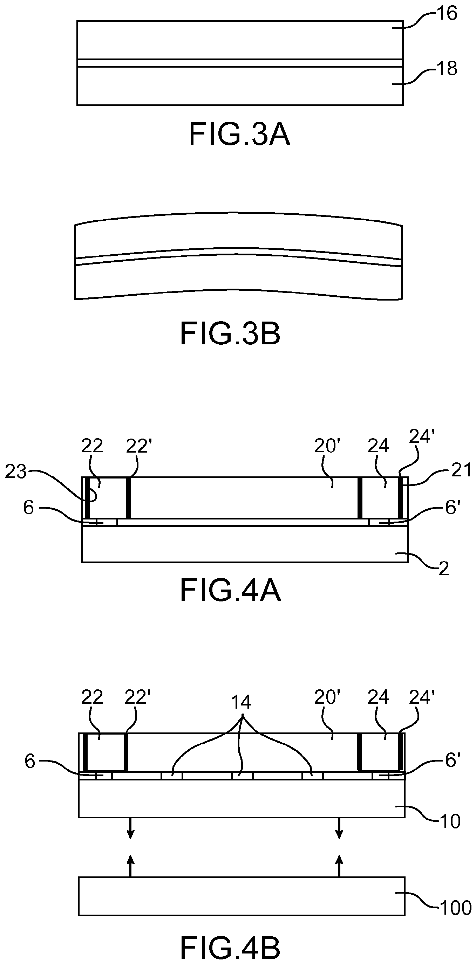

La figure 3A représente justement l'assemblage d'une poignée transparente 16 avec une plaquette 18, à température élevée.

La situation, après retour à température ambiante, est représentée en figure 3B, sur laquelle une déformation apparaît.

Cette déformation induit des problèmes de manipulation dans des équipements de microélectronique. Par ailleurs elle dégrade la résolution des motifs obtenus par photolithographie.

Il se pose donc le problème de trouver une autre technique, qui permet d'éviter l'utilisation d'une poignée en un matériau présentant un coefficient de dilatation thermique trop différent de celui du substrat auquel il est appliqué.

Une plaquette poignée comportant une fenêtre, en un matériau solide, de visualisation est mentionnée dans le document US 2009/0017580 A1.

### EXPOSÉ DE L'INVENTION

L'invention concerne d'abord un procédé, selon la revendication 1, de réalisation d'une plaquette poignée pour un substrat ou composant microélectronique, ou une plaquette fonctionnelle microélectronique.

On entend par « plaquette fonctionnelle » toute structure de micro-électronique, par exemple un «wafer», comportant des composants de dimensions michroniques.

En outre, on comprend par « fenêtre de visualisation », tout élément en un matériau transparent à la longueur d'onde utilisée, le plus souvent dans le domaine visible, pour visualiser les marques dans les zones d'alignement. Ce matériau est un solide. Enfin, les zones d'alignement peuvent comporter une ou plusieurs marques d'alignement.

La section des cavités, dans un plan de la plaquette, peut-être quelconque : une cavité peut avoir une section circulaire ou polygonale.

Cette section peut avoir une surface qui peut être comprise entre par exemple quelques millimètres carrés et quelques centimètres carrés, par exemple comprise entre 5 mm² et 10 cm².

Chaque cavité comporte une ouverture, dans une première face de la plaquette poignée, par laquelle le matériau de la fenêtre transparente est introduit, tandis que le fond de la cavité est soit fermé, et de préférence plan, soit repose sur une surface, de préférence plane, alignée avec une deuxième face de la plaquette poignée, sensiblement parallèle à la première face. Il y a donc une surface d'alignement ou d'accueil qui permet de positionner la fenêtre ou son matériau dans chaque cavité.

On peut retirer le substrat support lors de l'étape d1), par un mouvement de cisaillement de la plaquette poignée et du substrat support. A cette fin, on utilise avantageusement une liaison adhésive de type polymère thermofusible.

Lors de l'étape c1 ou b2), on peut insérer dans ladite cavité un matériau liquide transparent ou de visualisation, qui est ensuite solidifié.

En variante, lors de l'étape c1) ou b2), on insère dans ladite cavité, sur tout ou partie de sa profondeur, au moins une fenêtre transparente ou de visualisation en un matériau solide.

Dans un procédé selon l'invention :
- la ou les fenêtre(s) peuvent être en verre borosilicaté ou en verre sodocalcique ou en verre fusible ou en silice fondue ou en silicone ou en polymère,
- et/ou la plaquette peut être en matériau semi-conducteur, ou en matériau céramique ou polymère.

L'invention concerne également un procédé de traitement ou de manipulation d'une plaquette fonctionnelle, selon la revendication 8.

Un traitement de la plaquette peut comporter par exemple au moins un amincissement et/ou en un assemblage avec un autre substrat. Après traitement de la plaquette fonctionnelle, la plaquette poignée peut être retirée ou conservée. Si elle est maintenue, elle joue alors le rôle d'un capot.

La plaquette peut comporter en outre au moins un composant, par exemple de type MEMS ou NEMS ou MOEMS.

### BRÈVE DESCRIPTION DES DESSINS

- Les figures 1A-1C représentent un procédé selon l'art antérieur,
- la figure 2 représente un assemblage d'un capot avec un substrat supportant des MEMS,
- les figures 3A-3B illustrent les problèmes de différences de CTE,
- les figures 4A-4C représentent des assemblages d'un substrat et d'une poignée obtenue par un procédé selon l'invention,
- la figure 4D représente un assemblage d'un substrat et d'une poignée obtenue par un procédé ne correspondant pas à l'invention,
- les figures 5A-5G représentent un premier procédé de réalisation selon l'invention,
- les figures 6A-6D représentent un deuxième procédé de réalisation selon l'invention,
- les figures 7A-7F représentent un troisième procédé de réalisation selon l'invention,
- la figure 8 représente un dispositif poignée obtenue par un procédé selon l'invention, en vue de dessus.

### EXPOSÉ DÉTAILLÉ DE MODES DE RÉALISATION PARTICULIERS

Un premier exemple de l'utilisation d'une poignée 20' obtenue par un procédé selon l'invention est représenté en figures 4A-4C.

Une plaquette 2 comporte, sur sa face avant 4, des marques d'alignement 6, 6', comme celle de la figure 1A. Cette plaquette est liée par sa face avant avec une plaquette 20, dite aussi plaquette poignée (figure 4A), mais cette dernière est munie de fenêtres 22, 24, qui permettent d'avoir accès à une vision des mires d'alignement 6, 6'.

La figure 4B représente une variante dans laquelle le substrat est du type présenté ci-dessus avec la figure 2 et dont la surface incorpore non seulement des marques d'alignement 6, 6', mais également des composants 14, par exemple un MEMS, un NEMS, un MOEMS etc...). Cette plaquette est liée par sa face avant avec une plaquette 20' poignée, elle aussi munie de fenêtres 22, 24, qui permettent d'avoir accès à une vision des mires d'alignement 6, 6'.

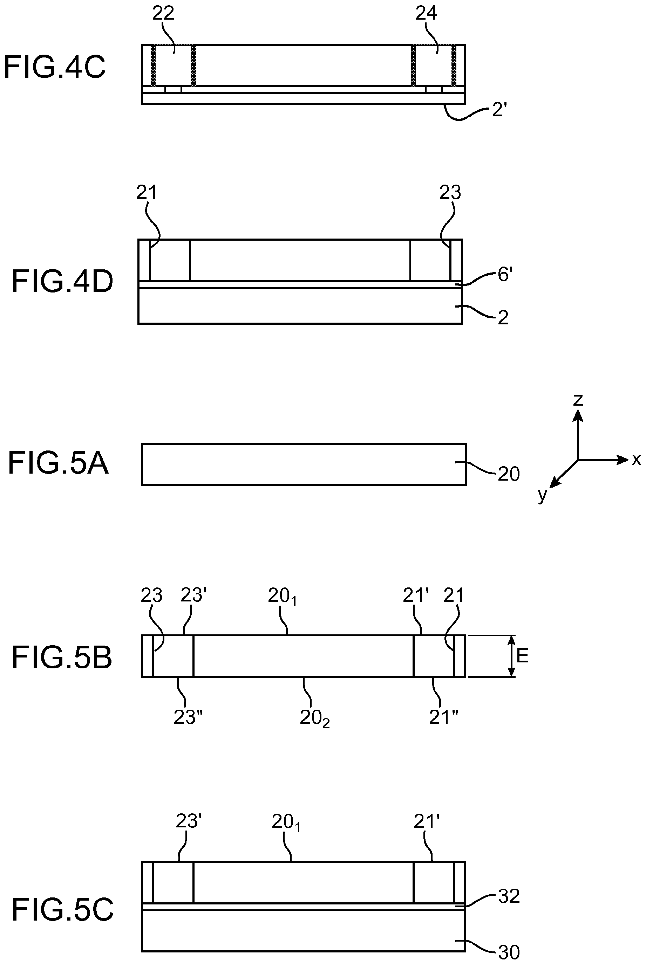

Dans le cas de la figure 4A, la plaquette 2 peut alors être amincie, puis traitée en face arrière 2', pour former la structure de la figure 4C. Le même résultat peut être obtenu avec la plaquette 10 de la figure 4B. D'autres traitements de la plaquette 2 peuvent être réalisés, en variante ou en combinaison avec un amincissement, par exemple un assemblage avec un autre substrat tel que le substrat 100 de la figure 4B.

Sur les figures 4A - 4C, l'espace, entre les fenêtres et les bords des trous 21, 23 réalisés dans la plaquette et dans lesquels des fenêtres sont réalisées, est comblé avec un revêtement 22', 24'.

Dans une variante ne correspondant pas à l'invention et exposée en figure 4D, on s'affranchit d'introduire ou de former une fenêtre, en particulier une fenêtre solide, dans ces trous. Plusieurs exemples de réalisation d'une plaquette poignée, selon l'invention, vont être décrits. On considère au départ de tous ces exemples une plaquette de départ 20 par exemple en silicium ou en un autre matériau semi-conducteur tel que l'AsGa, ou une céramique ou un polymère (figures 5A, 6A, 7A). Ainsi la plaquette dans laquelle seront intégrées les fenêtres a un coefficient de dilatation thermique (CTE) équivalent à, ou proche de, celui de la plaquette à traiter (ou encore plaquette fonctionnelle), qui sera reportée ensuite sur la plaquette munie des fenêtres. En général la plaquette à traiter est en matériau semi-conducteur, par exemple en silicium.

La plaquette qui va permettre de former la plaquette poignée a une extension dans un plan xy. Son épaisseur E, mesurée suivant une direction z perpendiculaire au plan xy, est faible, par exemple comprise entre quelques centaines de micromètres et quelques millimètres, par exemple encore comprise entre 100 µm et 1 mm ou 5 mm.

On réalise, par gravure, des cavités 21, 23 41, 43, 61, 63 dans cette plaquette 20 (figures 5B, 6B, 7B). Parmi les techniques que l'on peut utiliser pour cette gravure, on peut citer les techniques par laser, ou par usinage ultrasonique, ou par sablage, ou par plasma, ou une technique chimique (notamment : gravure au KOH, au TMAH, ou au fluorure de Xénon).

Dans les divers exemples donnés, les fenêtres sont en un matériau solide et sont insérées en matériau solide ou en matériau liquide et ensuite solidifié. Des exemples sont des fenêtres en verre borosilicaté ou en verre sodocalcique ou en verre fusible ou en silice fondue ou en silicone ou en époxy.

Le premier exemple va être décrit en liaison avec les figures 5A-5F.

Comme expliqué ci-dessus, on réalise, par gravure, des cavités 21, 23 dans la plaquette poignée 20 (figure 5B). Les cavités obtenues 21, 23 obtenues sont ici traversantes, elles ont donc une épaisseur identique à celle E de la plaquette elle-même.

On reporte cette plaquette, munie de ses cavités, temporairement sur un support 30 à surface plane, munie d'une couche d'adhésif 32 (figure 5C). Ce dernier est par exemple de type thermofusible, dont l'adhésion peut être éliminée par chauffage.

Chaque cavité comporte initialement une ouverture 21', 23', dans une première face principale 20₁ de la plaquette poignée 20, par laquelle le matériau de la fenêtre transparente sera ensuite introduit. Par report sur la plaquette support 30, on ferme la deuxième ouverture 21", 23" de chaque cavité. Ainsi le fond de la cavité repose sur une surface plane alignée avec une deuxième face 20₂ de la plaquette poignée 20, sensiblement parallèle à la première face 20₁.

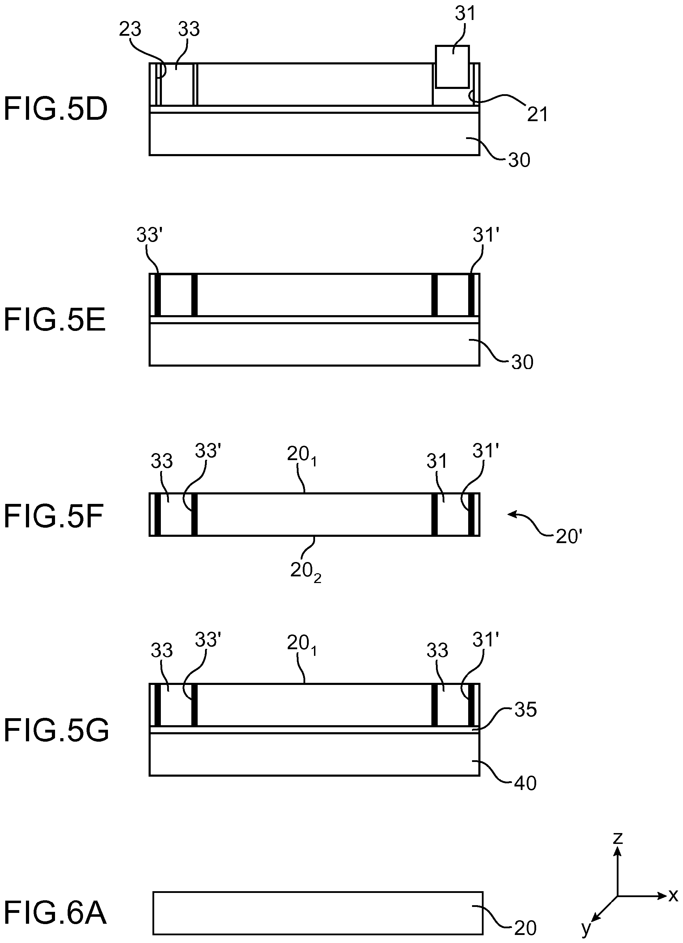

On peut ensuite positionner ou introduire une fenêtre transparente 31, 33, par exemple en verre, en quartz ou en polymère, dans chaque cavité 21, 23 (figure 5D). Le support 30, ou la surface de sa couche d'adhésif opposée à la surface du support 30 sur laquelle cette couche repose, fournit une surface plane d'accueil ou d'alignement pour positionner correctement la fenêtre dans la cavité, dans la direction verticale z, perpendiculaire au plan xy de la plaquette 20. Mais la fenêtre peut ne pas remplir la cavité et en particulier être en retrait par rapport à cette surface d'accueil.

On procède alors à un scellement de ces fenêtres dans ces cavités. Le matériau de scellement est désigné sur la figure 5E par les références 31',33'.

Il est ensuite possible de retirer le support 30 (figure 5F) par élimination de l'adhésif, ce qui libère la deuxième face 20₂ de la plaquette. Les fenêtres 31, 33 sont alors exposées au niveau de chacune des deux faces 20₁, 20₂.

On peut également procéder à un polissage des faces avant et arrière de la plaquette 20' ainsi obtenue pour disposer d'une qualité optique.

La plaquette 20' avec ses fenêtres 31, 33 peut être ensuite reportée sur une autre plaquette 40 par des technologies connues, par exemple de type "wafer bonding", à l'aide d'une résine 35, d'un matériau fusible de type eutectique ou par scellement anodique (figure 5G). Cette plaquette 40 peut être du type de la plaquette 2 ou de la plaquette 10 décrites ci-dessus, respectivement en liaison avec les figures 1A et 2, et comporter des mires ou des marques d'alignement comme déjà expliqué. Ces mires ou marques, positionnées en face avant, pourront être vues à travers les fenêtres de la poignée et ainsi être utilisées pour permettre un alignement de la face arrière.

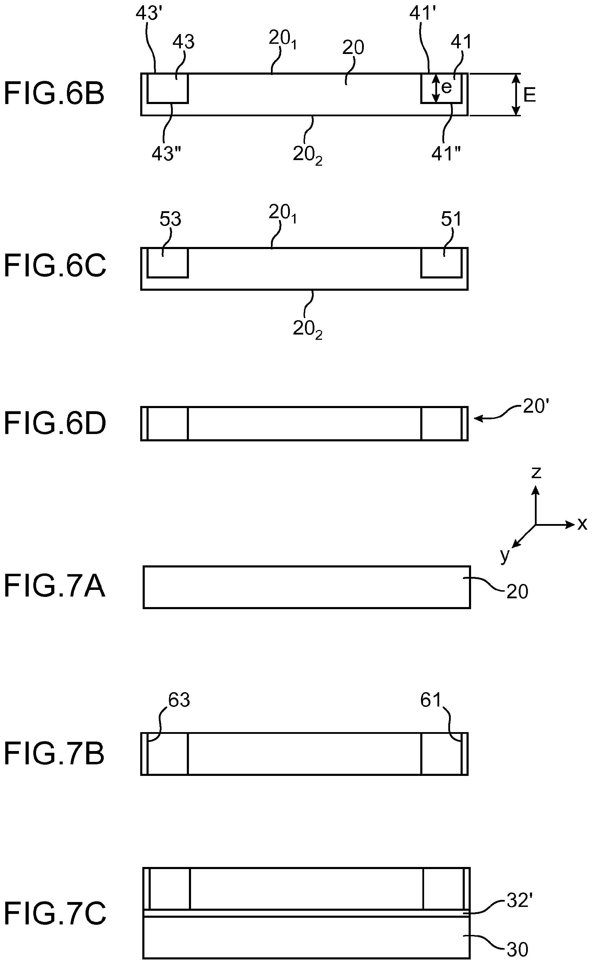

Un autre exemple de réalisation est représenté en figures 6A-6D.

Dans la plaquette 20 de départ (figure 6A), on réalise, ici encore par gravure, des cavités 41, 43 dans cette plaquette. A la différence du mode de réalisation exposé précédemment, les cavités obtenues 41, 43 ne sont ici pas traversantes, elles ont donc une profondeur e inférieure à l'épaisseur E de la plaquette elle-même.

On procède ensuite au remplissage de ces cavités avec un matériau 51, 53 transparent, mais cette fois à l'état liquide, ou pâteux, alors que les fenêtres 31, 33 de l'exemple précédent étaient introduites dans les cavités 21, 23 en étant à l'état solide. On peut choisir ici, par exemple, le verre fusible ou la silice fondue ou un polymère polymérisable, UV ou thermique par exemple. Ce matériau est ensuite solidifié, dans des conditions de température le permettant.

Chaque cavité comporte une ouverture 41', 43', dans la première face principale 20₁ de la plaquette poignée 20, par laquelle le matériau de la fenêtre transparente est introduit. Le fond non gravé 41", 43" de chaque cavité 41, 43 définit une surface plane pour positionner correctement le matériau de chaque fenêtre dans la cavité correspondante, dans un plan parallèle au plan xy de la plaquette 20 et suivant la direction verticale z, perpendiculaire au plan xy de la plaquette 20.

On peut procéder ensuite à un amincissement de la plaquette, jusque, au moins, au niveau du fond 41", 42" de chaque cavité, afin de faire apparaître, sur chacune des deux faces principales 20₁, 20₂ de la plaquette, la fenêtre transparente ainsi réalisée, le matériau transparent étant maintenant solide. On élimine ainsi la différence d'épaisseur entre la plaquette 20 et les cavités 41, 43. On réalise en outre, éventuellement, un polissage des faces avant et arrière de la plaquette amincie, afin d'obtenir une qualité optique.

Ce mode de réalisation ne nécessite pas la mise en oeuvre d'une plaquette d'appoint (ou support), comme la plaquette 30 du mode de réalisation précédent. L'alignement des fenêtres dans le deuxième plan de la poignée est avantageusement réalisé grâce au fond 41", 43" de chaque cavité. Ce mode de réalisation permet en particulier d'utiliser un matériau initialement liquide.

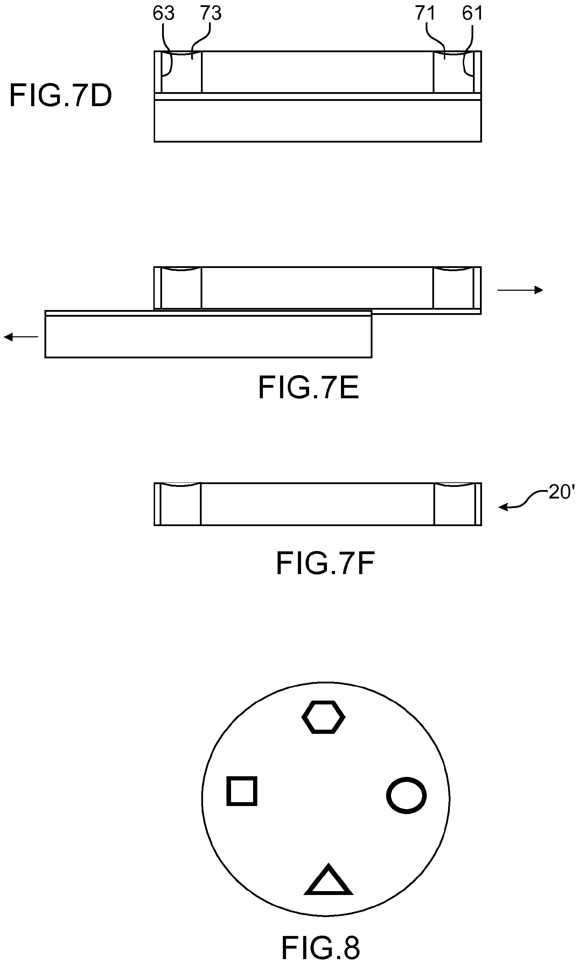

Un autre exemple de réalisation est représenté en figures 7A - 7F.

Là encore, partant d'une plaquette de départ 20 on réalise, par gravure, des cavités 61, 63 dans cette plaquette (figure 7B). A la différence du mode de réalisation exposé précédemment, les cavités obtenues 61, 63 sont ici de nouveau traversantes, elles ont donc une profondeur e égale à l'épaisseur E de la plaquette elle-même.

On reporte cette plaquette, munie de ses cavités, temporairement sur un support 30 avec un adhésif 32' (figure 7C) pour former une surface plane d'alignement ou d'accueil. L'adhésif est par exemple de type thermofusible, dont l'adhésion peut être éliminée par chauffage, par exemple du type de celle développée par Breewer Science pour le collage de plaquette temporaire.

Le rôle de ce support 30 et/ou de son adhésif 32', pour l'alignement ou le positionnement des fenêtres, suivant l'axe z perpendiculaire au substrat, est le même que dans le cas du mode de réalisation expliqué ci-dessus en liaison avec les figures 5A - 5G.

On procède ensuite au remplissage de ces cavités avec un matériau 71, 73 transparent, à l'état liquide (figure 7D), par exemple un polymère transparent de type époxy ou silicone. Ce matériau est ensuite solidifié, dans des conditions de température le permettant.

Il est ensuite possible de retirer le support 30 (figure 7E), par cisaillement à haute température de la couche 32.

On peut également procéder à un nettoyage et/ou un polissage des faces avant et arrière de la plaquette 20' ainsi obtenue pour disposer d'une qualité optique.

Quel que soit le mode de réalisation choisi, les fenêtres peuvent être suffisamment larges pour être visibles par tout type d'équipement d'alignement ou bien dédiée à une application ou un équipement particulier. Par exemple une fenêtre a une largeur, ou dimension maximale, mesurée suivant une direction parallèle à la surface du substrat 20, de l'ordre de quelques dizaines de µm à quelques centaines de µm ou quelques mm, par exemple comprise entre 100 µm et 3 mm ou 5 mm.

Avantageusement les fenêtres d'un substrat poignée obtenu par un procédé selon l'invention ont des faces polies de façon à ne pas perdre en résolution.

Une fenêtre de visualisation d'un substrat poignée obtenu par un procédé selon l'invention a de préférence une transparence à un rayonnement dans un domaine spectral d'observation, qui comporte au moins une partie du spectre visible (la plupart des équipements de photolithographie comportent des caméras sensibles dans le domaine du visible) ou par exemple entre, d'une part, 400 nm ou 450 nm ou 500 nm et, d'autre part, 600 nm ou 700 nm ou 750 nm. Le matériau transparent de la fenêtre pourra être par exemple un verre ou un polymère. Un équipement, en particulier pour la photolithographie, peut comporter au moins un substrat tel qu'il a été décrit ci-dessus, avec une caméra sensible dans au moins un domaine spectral, par exemple au moins l'un de ceux qui viennent d'être énoncés, dans lequel au moins une fenêtre du substrat est au moins en partie transparente.

## Revendications

1. Procédé de réalisation d'une plaquette (20') poignée pour un substrat ou composant microélectronique, ou une plaquette fonctionnelle microélectronique, cette plaquette poignée comportant au moins une fenêtre (31, 33, 51, 53, 61, 63), en un matériau solide, de visualisation à travers l'épaisseur de la plaquette poignée, ce procédé comportant :
a1) la réalisation d'au moins une cavité traversante (21, 23, 61, 63) dans une plaquette de départ (20),
b1) l'assemblage de ladite plaquette de départ avec un substrat support (30), éventuellement à l'aide d'une couche adhésive (32, 32'), le substrat support (30) ou la surface de ladite couche adhésive (32, 32') opposée à la surface du substrat support (30) sur laquelle ladite couche adhésive repose définissant une surface d'alignement ou d'accueil ;
c1) la formation d'au moins une fenêtre de visualisation (31, 33, 71, 73) dans ladite au moins une cavité traversante, sur ladite surface d'alignement ou d'accueil (32, 32');
d1) puis le retrait du substrat support (30) ;
ou bien ce procédé comportant:
a2) la réalisation, dans une plaquette de départ (20), d'au moins une cavité non traversante (41, 43), dont le fond (41",43") définit une surface d'accueil ;
b2) la formation d'au moins une fenêtre de visualisation (51, 53) dans ladite au moins une cavité non traversante, sur ladite surface d'accueil (32, 32') ;
c2) puis l'élimination d'une partie de l'épaisseur de la plaquette de départ (20) afin que ladite au moins une cavité soit traversante dans la plaquette amincie (20').

2. Procédé selon la revendication 1, dans lequel, lors de l'étape b1), ladite plaquette de départ (20) et le substrat support (30) sont assemblés à l'aide d'une couche adhésive (32, 32') formant une liaison adhésive réversible.

3. Procédé selon la revendication 2, dans lequel, lors de l'étape d1), on retire le substrat support (30) par un mouvement de cisaillement de la plaquette de départ (20) et du substrat support.

4. Procédé selon l'une des revendications 1 à 3, dans lequel, lors de l'étape c1) ou b2), on insère dans ladite cavité un matériau liquide de visualisation (51, 53, 71, 73), qui est ensuite solidifié.

5. Procédé selon l'une des revendications 1 à 3, dans lequel, lors de l'étape c1) ou b2), on insère dans tout ou partie de ladite cavité au moins une fenêtre de visualisation (31, 33) en un matériau solide.

6. Procédé selon l'une des revendications 1 à 5, dans laquelle la ou les fenêtre(s) est, ou sont, en en verre borosilicaté ou en verre sodocalcique ou en verre fusible ou en silice fondue ou en silicone ou en polymère.

7. Procédé selon l'une des revendications 1 à 6, la plaquette de départ étant en matériau semi-conducteur, ou en matériau céramique ou polymère.

8. Procédé de traitement ou de manipulation d'une plaquette (2) fonctionnelle comportant au moins une zone d'alignement (6, 6'), comportant :
- la formation d'une plaquette (20') poignée selon l'une des revendications 1 à 7 ;
- l'assemblage de ladite plaquette (2) fonctionnelle avec ladite plaquette poignée (20'), de sorte qu'une fenêtre permet de visualiser tout ou partie d'au moins une zone d'alignement à travers ladite plaquette poignée, puis éventuellement le traitement de ladite plaquette fonctionnelle.

9. Procédé selon la revendication 8, la plaquette fonctionnelle (2) comportant en outre au moins un composant (14).

10. Procédé selon la revendication 9, ledit composant (14) étant un MEMS ou un NEMS ou un MOEMS.

11. Procédé selon l'une des revendications 8 à 10, ladite plaquette poignée étant éliminée après traitement de ladite plaquette fonctionnelle.

## Patentansprüche

1. Verfahren zur Herstellung eines Griff-Wafers (20') für ein mikroelektronisches Substrat oder Bauteil, oder für einen funktionellen mikroelektronischen Wafer, wobei dieser Griff-Wafer wenigstens ein Fenster (31, 33, 51, 53, 61, 63) aus einem festen Material umfasst, zur Sichtbarmachung durch die Dicke des Griff-Wafers hindurch, wobei das Verfahren umfasst:
a1) das Erstellen wenigstens einer Durchgangsausnehmung (21, 23, 61, 63) in einem Ausgangs-Wafer (20),
b1) das Zusammensetzen des Ausgangs-Wafers mit einem Trägersubstrat (30), gegebenenfalls mit Hilfe einer Adhäsionsschicht (32, 32'), wobei das Trägersubstrat (30) oder die Oberfläche der Adhäsionsschicht (32, 32'), die der Oberfläche des Trägersubstrats (30) gegenüberliegt, auf welcher die Adhäsionsschicht ruht, eine Ausrichtungsfläche oder Aufnahmefläche definiert,
c1) die Bildung von wenigstens einem Sichtfenster (31, 33, 71, 73) in der wenigstens einen Durchgangsausnehmung auf der Ausrichtungsfläche oder Aufnahmefläche (32, 32')
d1) danach das Entfernen des Trägersubstrats (30),
oder aber wobei das Verfahren umfasst:
a2) das Erstellen wenigstens einer nicht durchgehenden Ausnehmung (41, 43) in einem Ausgangs-Wafer (20), deren Boden (41", 43") eine Aufnahmefläche definiert,
b2) die Bildung von wenigstens einem Sichtfenster (51, 53) in der wenigstens einen nicht durchgehenden Ausnehmung auf der Aufnahmefläche (32, 32'),
c2) dann die Eliminierung von einem Teil der Dicke des Ausgangs-Wafers (20), damit die wenigstens eine Ausnehmung in dem dünner gemachten Wafer (20') durchgängig ist.

2. Verfahren nach Anspruch 1, wobei bei dem Schritt b1) der Ausgangs-Wafer (20) und das Trägersubstrat (30) mit Hilfe einer Adhäsionsschicht (32, 32') zusammensetzt werden, wobei eine reversible Adhäsionsverbindung gebildet wird.

3. Verfahren nach Anspruch 2, wobei bei dem Schritt d1) das Trägersubstrat (30) durch eine Scherbewegung des Ausgangs-Wafers (20) und des Trägersubstrats entfernt wird.

4. Verfahren nach einem der Ansprüche 1 bis 3, wobei bei dem Schritt c1) oder b2) in die Ausnehmung ein flüssiges Sicht-Material (51, 53, 71, 73) eingebracht wird, welches anschließend verfestigt wird.

5. Verfahren nach einem der Ansprüche 1 bis 3, wobei bei dem Schritt c1) oder b2) in die gesamte Ausnehmung oder einen Teil davon wenigstens ein Sichtfenster (31, 33) aus einem festen Material eingesetzt wird.

6. Verfahren nach einem der Ansprüche 1 bis 5, wobei das Fenster oder die Fenster aus einem Borsilikatglat oder einem Kalk-Natron-Glas oder aus einem schmelzbaren Glas oder aus Quarzglas oder aus Silikon oder aus einem Polymer besteht oder bestehen.

7. Verfahren nach einem der Ansprüche 1 bis 6, wobei der Ausgangs-Wafer aus einem Halbleitermaterial oder aus einem Keramikmaterial oder aus einem Polymermaterial besteht.

8. Verfahren zur Bearbeitung oder Handhabung eines funktionellen Wafers (2), der wenigstens einen Ausrichtungsbereich (6, 6') umfasst, umfassend:
- die Bildung eines Griff-Wafers (20') nach einem der Ansprüche 1 bis 7,
- das Zusammensetzen des funktionellen Wafers (2) mit dem Griff-Wafer (20'), so dass ein Fenster erlaubt, wenigstens einen Ausrichtungsbereich ganz oder teilweise durch den Griff-Wafer hindurch sichtbar zu machen, danach gegebenenfalls die Bearbeitung des funktionellen Wafers.

9. Verfahren nach Anspruch 8, wobei der funktionelle Wafer (2) weiterhin wenigstens ein Bauteil (14) umfasst.

10. Verfahren nach Anspruch 9, wobei das Bauteil (14) ein MEMS oder ein NEMS oder ein MOEMS ist.

11. Verfahren nach einem der Ansprüche 8 bis 10, wobei der Griff-Wafer nach der Bearbeitung des funktionellen Wafers eliminiert wird.

## Claims

1. Method for making a handle wafer (20') for a microelectronic substrate or component, or a microelectronic functional wafer, said handle wafer including at least one window (31, 33, 51, 53, 61, 63), in a solid material for viewing through the thickness of the handle wafer, this method including:
a1) - the making of at least one through-cavity (21, 23, 61, 63) in a starting wafer (20),
b1) - the assembling of said starting wafer with a supporting substrate (30), possibly by means of adhesive layer (32, 32'), the supporting substrate (30), or the surface of said of adhesive layer (32, 32') opposed to the surface of the supporting substrate (30) on which this adhesive layer lies, defining an alignment or receiving surface;
c1) - the formation of at least one viewing window (31, 33, 71, 73) in said of at least one through-cavity, on said alignment or receiving surface (32, 32');
d1) then the removal of said supporting substrate (30);
or this method comprising:
a2) - the making, in a starting wafer (20), of at least one non-through-cavity (41, 43), the bottom of which (41", 43") defines a receiving surface;
b2) - the formation of at least one viewing window (51, 53) in said at least one non-through-cavity, on said receiving surface (32, 32');
c2) then the removal of a portion of the thickness of the starting wafer (20) so that said at least one cavity is a through-cavity in the thinned wafer (20').

2. Method according to claim 1, wherein, during step d1), said starting wafer (20) and the supporting substrate (30) are assembled by means of an adhesive layer (32, 32') forming a reversible adhesive bond.

3. Method according to claim 2, wherein, during step d1), the supporting substrate (30) is removed after step b), by a shearing movement of the starting wafer (20) and of the supporting substrate.

4. Method according to any of claims 1 to 3, wherein during step c1) or b2), a liquid viewing material (51, 53, 71, 73) is inserted into said cavity and is then solidified.

5. Method according to any of claims 1 to 3, wherein during step c1) or b2), at least one viewing window (31, 33) in a solid material is inserted in all or part of said cavity.

6. Method according to any of claims 1 to 5, wherein the window(s) is (are) in borosilicate glass or in sodocalcic glass or in fusible glass or in fused silica or in silicone or in polymer.

7. Method according to any of claims 1 to 6, the starting wafer being in a semiconducting material, or in a ceramic or polymeric material.

8. Method for treating or handling a functional wafer (2) including at least one alignment area (6, 6'), comprising:
- making a handle wafer (20') according to any of claims 1 to 7;
- assembling said functional wafer (2) with said handle wafer (20'), so that a window allows all or part of at least one alignment area to be viewed through said handle wafer, and then a possible treatment of said functional wafer.

9. Method according to claim 8, the functional wafer (2) further including at least one component (14).

10. Method according to claim 9, said component (14) being an MEMS or an NEMS or an MOEMS.

11. Method according to any of claims 8 to 10, said handle wafer being removed after treatment of said functional wafer.
